# EUROPÄISCHE PATENTSCHRIFT

(11) **EP 0 500 037 B1**
(45) Veröffentlichungstag und Bekanntmachung des Hinweises auf die Patenterteilung: **07.02.1996**
(21) Anmeldenummer: 92102668.8
(22) Anmeldetag: 18.02.1992
(51) Int. Cl.: H04B 1/10, H03G 11/00, H03H 11/04

(54) **Schaltungsanordnung zur Unterdrückung von Störsignalen**
Circuit for suppressing noise
Circuit pour supprimer des bruits

(30) Priorität: 19.02.1991 DE 4105123
(43) Veröffentlichungstag der Anmeldung: 26.08.1992
(73) Patentinhaber: BECKER GmbH, D-76307 Karlsbad (DE)
(72) Erfinder: Brinkhaus, Stefan, W-7537 Remchingen-Wilferdingen (DE)
(74) Vertreter: Degwert, Hartmut, Dipl.-Phys.

(56) Entgegenhaltungen:
- GB-A- 2 029 177
- US-A- 4 204 170
- US-A- 4 571 548
- US-A- 4 742 570

## Beschreibung

Die Erfindung betrifft eine Schaltungsanordnung zur Unterdrückung von Störsignalen gemäß dem Oberbegriff des Anspruchs 1 und des Anspruchs 2, die z. B. bereits aus US-A-4 204 170 bekannt sind.

In einem elektrischen Signal, das eine Niederfrequenz-Information enthält, beispielsweise ein Sprach- oder Musiksignal, können Störsignale auftreten, die auf verschiedene Ursachen zurückgehen. Als besonderes Anwendungsbeispiel wird in der folgenden Beschreibung ein Rundfunkempfänger betrachtet, insbesondere ein Rundfunkempfänger für mobilen Betrieb, beispielsweise ein Autoradio. Das hinter dem Demodulator des Empfangsteils entnommene Multiplex-Signal enthält bekanntlich das Summen- und das Differenzsignal der beiden Stereokanäle, den Pilotton und weitere Kennungssignale. Zusätzlich treten Störsignale auf, die nicht nur durch verschiedene elektromagnetische Störquellen, sondern auch durch Empfangsstörungen wie Mehrwegeempfang verursacht werden. Die Störsignale sind impulsförmig und oft von sehr kurzer Dauer, was einer gegenüber dem NF-Bereich hohen Frequenz entspricht.

Zur Unterdrückung dieser Störsignale kommen verschiedene mehr oder weniger aufwendige Methoden in Betracht. Die wohl einfachste Methode besteht darin, im Signalweg ein RC-Glied mit integrierendem Verhalten anzuordnen. Durch ein solches RC-Glied werden zwar die Impulsspitzen der Störsignale in ihrer Amplitude vermindert, jedoch wird die Dauer der Störimpulse durch das integrierende Verhalten des RC-Gliedes vergrößert. Eine Vergrößerung der Dauer der Störsignalimpulse kann aber zu Frequenzanteilen führen, die in den NF-Bereich fallen, so daß eher eine Verschlechterung des subjektiven Höreindrucks entsteht.

Ferner kommt in Betracht, Störsignalimpulse auszustasten und das NF-Signal während der Austastzeitspannen zu überbrücken. Diese Methode erfordert aber, wenn sie gute Ergebnisse erzielen soll, einen erheblichen technischen Aufwand.

Der Erfindung liegt die Aufgabe zugrunde, eine Schaltungsanordnung zur Unterdrückung von Störsignalen zur Verfügung zu stellen, die sich durch hohe Wirksamkeit bei geringstem Aufwand auszeichnet.

Diese Aufgabe wird erfindungsgemäß bei einer Schaltungsanordnung der eingangs angegebenen Art durch die Merkmale des kennzeichenden Teils des Anspruchs 1 und des Anspruchs 2 gelöst. Durch diese Maßnahme wird die Amplitude der Störimpulse auf einen Wert begrenzt, der auf die jeweilige Augenblicksamplitude des geglätteten Signals hinter dem RC-Glied bezogen ist. Vor dem RC-Glied liegt daher die Augenblicksamplitude des Signals innerhalb eines begrenzten Bereiches oberhalb und unterhalb der Augenblicksamplitude des geglätteten Signals. Die nunmehr durch das RC-Glied geglätteten Störimpulse sind von begrenzter Höhe, so daß der Integrationseffekt nicht zur Erzeugung von störenden Signalkomponenten führen kann, die innerhalb des hörbaren NF-Bereiches liegen würden.

Die Begrenzung gegenüber einem Bezugssignal, welches dem durch das RC-Glied geglätteten Signal entspricht, kann mit sehr einfachen Mitteln verwirklicht werden. Wenn dem RC-Glied ein Impedanzwandler nachgeschaltet ist, vorzugsweise ein rückgekoppelter Differenzverstärker, so liefert der Ausgang dieses Impedanzwandlers das Bezugssignal. An den Ausgang des Impedanzwandlers sind zwei antiparallel geschaltete Dioden mit einem Anschluß angeschlossen, und der andere Anschluß des Diodenpaares ist mit dem Eingang des RC-Gliedes verbunden, dem ein Arbeitswiderstand des Spannungsteilers vorausgeht. Die Dioden bilden das nichtlineare Element des Spannungsteilers.

Bei Anwendung der Schaltungsanordnung auf das Multiplex-Signal eines Rundfunkempfängers hat die Anwesenheit des RC-Gliedes im Signalweg zur Folge, daß die obere Grenzfrequenz des Signals herabgesetzt wird. Ein Stereo-Empfang ist unter diesen Umständen nicht oder nur eingeschränkt möglich. Gemäß einer bevorzugten Ausführungsform wird daher der Kondensator des RC-Gliedes über einen Schalter zu- und abgeschaltet; die Steuerung des Schalters erfolgt durch einen Störungsdetektor, der das elektrische Signal analysiert und Störungen unmittelbar nach ihrem Auftreten erkennt. Der Schalter ist also im Normalfalle geöffnet und wird nur beim Auftreten von Störimpulsen vorübergehend geschlossen. Alternativ wird anstelle eines Schalters ein veränderlicher Widerstand verwendet, dessen Widerstandswert durch ein Qualitätsbewertungssignal steuerbar ist, dessen Pegel eine Funktion des Störsignalanteils in dem elektrischen Signal ist. Bei unwirksamem RC-Glied stimmt das Bezugssignal vollkommen mit dem ursprünglichen elektrischen Signal überein; das elektrische Signal durchläuft die Schaltungsanordnung ohne jegliche Qualitätseinbuße. Bei zugeschaltetem Kondensator erfolgt hingegen eine Störsignalunterdrückung, deren Wirkung durch Dimensionierung des RC-Gliedes und geeignete Wahl des Pegels, bei dem die Begrenzung durch das nichtlineare Element einsetzt, nach subjektivem Hörempfinden optimiert werden kann.

Eine einfache Möglichkeit zur Bestimmung des Punktes, an dem die Begrenzung durch das nichtlineare Element erfolgt, besteht darin, dem Spannungsteiler einen Verstärker vorzuschalten, dessen Verstärkungsfaktor an die Kenndaten der verwendeten Dioden angepaßt werden kann. Eine einfache Beeinflussungsmöglichkeit besteht in der Auswahl von Dioden mit der geeigneten Schwellspannung. Schließlich ist es auch mit relativ einfachen schaltungstechnischen Maßnahmen möglich, eine Vorspannung an die Dioden anzulegen, um ihren Schwellwert relativ zum Pegel des Bezugssignals zu verlagern.

Weitere Merkmale und Vorteile der Erfindung ergeben sich aus der folgenden Beschreibung und aus der Zeichnung, auf die Bezug genommen wird. In der Zeichnung zeigen:
- Fig. 1: ein Schaltbild einer ersten Ausführungsform der Schaltungsanordnung;
- Fig. 2a, b und c: Signaldiagramme zur Erläuterung der Wirkungsweise der Schaltungsanordnung; und
- Fig. 3: ein Schaltbild einer zweiten Ausführungsform.

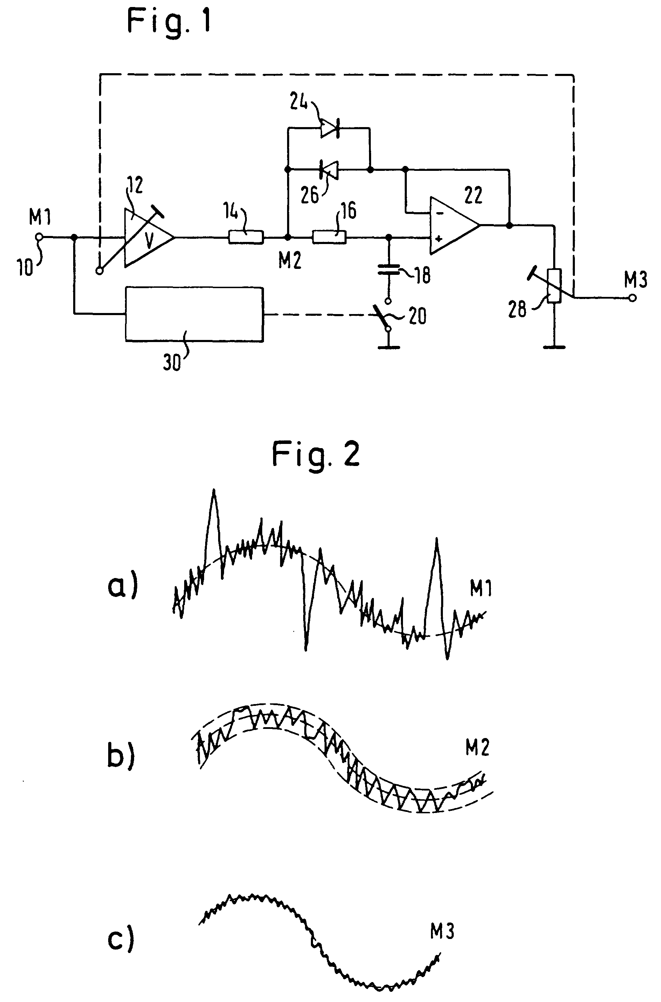

Die in Fig. 1 gezeigte Schaltungsanordnung ist zur Verwendung in einem mobilen Rundfunkempfänger bestimmt. An den Eingang 10 der Schaltungsanordnung wird das hinter dem Demodulator des Empfangsteils abgenommene Multiplex-Signal angelegt, das mit M1 bezeichnet ist. Dieses Signal ist in Fig. 2a gezeigt. Das Signal M1 wird in einem Verstärker 12, der auf den Verstärkungsfaktor V eingestellt ist, verstärkt und dem Arbeitswiderstand 14 eines Spannungsteilers zugeführt. Auf den Arbeitswiderstand 14 folgt der Widerstand 16 eines RC-Gliedes mit integrierendem Verhalten, dessen Kondensator 18 über einen Schalter 20 mit Masse verbindbar ist. Der nichtinvertierende Eingang eines Differenzverstärkers 22, dessen Ausgang auf seinen invertierenden Eingang rückgekoppelt ist, ist mit dem Verbindungspunkt zwischen dem Widerstand 16 und dem Kondensator 18 verbunden. Der Ausgang des Differenzverstärkers 22 ist über zwei antiparallel geschaltete Dioden 24, 26 mit dem Verbindungspunkt zwischen den Widerständen 14, 16 verbunden. Das Diodenpaar 24, 26 bildet ein nichtlineares Element eines Spannungsteilers, dessen Arbeitswiderstand der Widerstand 14 ist. Das Ausgangssignal des als Impedanzwandler wirkenden Differenzverstärkers 22 wird über ein Potentiometer 28 abgenommen. Die Verstellung des Potentiometers 28 erfolgt im Gleichlauf mit der Änderung des Verstärkungsfaktors V des Verstärkers 12. Das am Potentiometer 28 abgenommene Ausgangssignal M3 hat daher denselben Pegel wie das Eingangssignal M1. An den Eingang 10 ist ferner ein Störungsdetektor 30 angeschlossen, der das Eingangssignal M1 analysiert und beim Auftreten von Störungen ein Ansteuersignal für den Schalter 20 abgibt, um diesen vorübergehend zu schließen. Der Störungsdetektor 30 ist in bekannter Weise ausgebildet und wird daher nicht näher beschrieben; er enthält vorzugsweise Filterschaltungen, die auf bestimmte Frequenzanteile im Eingangssignal M1 ansprechen, insbesondere Frequenzanteile, die für das Auftreten von Mehrweg-Empfangsstörungen charakteristisch sind.

Alternativ wird der Schalter 20 durch ein feldstärkeabhängiges Signal oder durch das im allgemeinen verfügbare Umschaltsignal zur Stereo/Mono-Umschaltung gesteuert. Bei Verwendung eines Störungsdetektors 30 kann dessen Eingangssignal abweichend von der in Fig. 1 gezeigten Ausführung durch das gewöhnlich von ZF-IC-Schaltungen abgegebene Feldstärkeanzeigesignal gebildet sein, auf dessen Grundlage eine besonders zuverlässige Störsignalerkennung möglich ist.

Die Arbeitsweise der Schaltungsanordnung wird nun unter Bezugnahme auf Fig. 2 beschrieben. Das in Fig. 2a gezeigte Multiplex-Signal M1 besteht aus einer als annähernd sinusförmig angenommenen Grundschwingung und einem dieser überlagerten Störsignal, dessen Frequenz ein Vielfaches der Frequenz der Grundschwingung ist. Der Störungsdetektor 30 erkennt das Störungssignal und bewirkt ein Schließen des Schalters 20. Zwischen den Widerständen 14 und 16 tritt dann das in Fig. 2b gezeigte Signal M2 auf, das dadurch entsteht, daß die Impulse des Störsignals in bezug auf den Augenblickspegel des Ausgangssignals M3 hinter dem Differenzverstärker 22 begrenzt werden. Die Begrenzung erfolgt dadurch, daß die Dioden 24, 26 ab einer bestimmten Schwellspannung oberhalb bzw. unterhalb des am Ausgang des Differenzverstärkers 22 abgenommenen Bezugssignals leitend werden und einen Spannungsabfall in dem Arbeitswiderstand 14 verursachen. Die Begrenzung erfolgt also gegenüber einem Bezugssignal, das am Ausgang des Differenzverstärkers 22 abgenommen wird und dem Ausgangssignal M3 entspricht. Bei geöffnetem Schalter 20 erfolgt keinerlei Veränderung des Eingangssignals M1, da das Bezugssignal am Ausgang des Differenzverstärkers 22 genau dem Signal M2 zwischen den Widerständen 14 und 16 entspricht. Wie aus Fig. 2c ersichtlich ist, ist das Ausgangssignal M3 weitgehend von Störsignalkomponenten befreit. Von besonderer Bedeutung ist, daß aufgrund der Anwendung der beschriebenen Begrenzungsmethode keine wesentliche Verbreiterung der verbleibenden Störsignalimpulse durch das RC-Glied 16, 18 erfolgt. Die Frequenz der Störsignalanteile wird daher kaum vermindert, so daß sie außerhalb des hörbaren NF-Bereiches verbleiben.

Wie aus Fig. 2b ersichtlich ist, liegen die Störsignalanteile im Signal M2 innerhalb einer Zone oberhalb und unterhalb der Grundschwingung, deren Breite durch die Schwellspannung der Dioden 24, 26 bestimmt wird. Die Breite dieser Zone kann relativ zur Amplitude des Signals M2 verändert werden, indem der Verstärkungsfaktor des Verstärkers 12 verändert wird. Auf diese Weise läßt sich leicht der Punkt bestimmen, ab welchem die Begrenzung erfolgen soll.

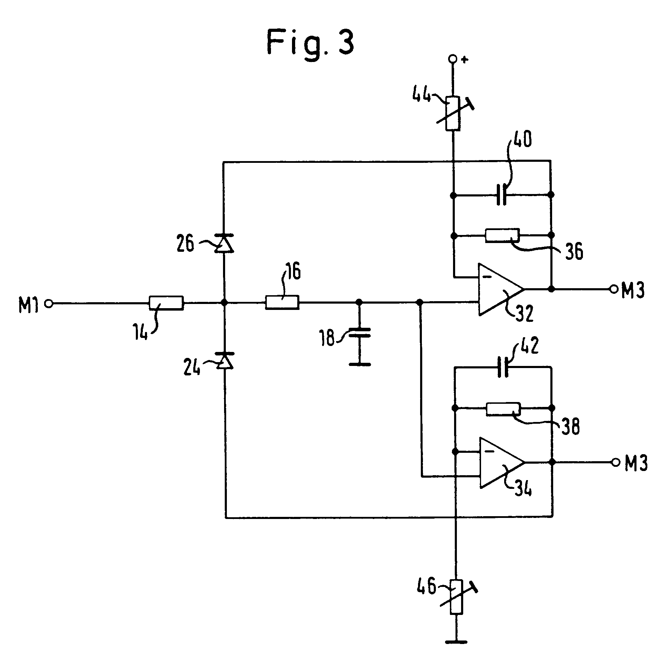

Bei der Ausführungsform nach Fig. 3 wird das Multiplex-Signal M1 direkt an den Arbeitswiderstand 14 angelegt, auf den das RC-Glied mit dem Widerstand 16 und dem Kondensator 18 folgt. Zwei Differenzverstärker 32, 34 sind parallel mit ihrem nichtinvertierenden Eingang an den Verbindungspunkt zwischen Widerstand 16 und Kondensator 18 angeschlossen. Beide Differenzverstärker 32, 34 sind über einen Widerstand 36 bzw. 38 und einen dazu parallelgeschalteten Kondensator 40 bzw. 42 auf den invertierenden Eingang rückgekoppelt. An diesen Eingang ist ferner über einen einstellbaren Widerstand 44 bzw. 46 ein festes Spannungspotential angelegt, im Falle des Widerstandes 44 ein positives Potential und im Falle des Widerstandes 46 das Massepotential. Der Ausgang des Differenzverstärkers 32 ist über eine Diode 26 mit dem Verbindungspunkt zwischen den Widerständen 14 und 16 verbunden; analog ist der Ausgang des Differenzverstärkers 34 über eine Diode 24 mit demselben Verbindungspunkt zwischen den Widerständen 14, 16 verbunden. Durch das Anlegen einer Vorspannung an die invertierenden Eingänge der Differenzverstärker 32, 34 werden ihre Ausgänge auf ein Gleichspannungspotential gelegt, so daß eine Vorspannung an den Dioden 24, 26 anliegt. Die Höhe dieser Vorspannung bestimmt den Einsatzpunkt der Begrenzung, die hinter dem Arbeitswiderstand 14 erfolgt. Dieser Einsatzpunkt kann durch Verändern der Widerstandswerte der Widerstände 44, 46 auf den gewünschten Wert eingestellt werden.

Auch bei der Ausführungsform nach Fig. 3 kann der Kondensator 18 über einen Unterbrecher zuschaltbar sein. Eine weitere Ausführungsform besteht darin, daß der Kondensator 18 in Reihe mit einem steuerbaren Widerstand liegt, dessen Widerstandswert durch ein Qualitätsbewertungssignal gesteuert wird. Im einfachsten Falle wird als steuerbarer Widerstand ein Feldeffekttransistor verwendet, an dessen Gate eine Spannung angeleg wird, deren Pegel eine Funktion des Störsignalanteils in dem Multiplex-Signal M1 ist. Beispielsweise werden aus dem Multiplex-Signal die hochfrequenten Signalanteile herausgefiltert, gleichgerichtet und gesiebt, um zu einem Qualitätsbewertungssignal zu gelangen, das zur Ansteuerung des Gates des Feldeffekttransistors geeignet ist.

## Patentansprüche

1. Schaltungsanordnung zur Unterdrückung von Störsignalen in einem eine NF-Information enthaltenden elektrischen Signal, mit einem im Signalweg liegenden integrierenden RC-Glied (16, 18), dem ein Spannungsteiler (14, 24, 26) vorgeschaltet ist, der ein nichtlineares Element (24, 26) enthält und eine Begrenzung innerhalb einer vorbestimmten Schwankungsbreite um das Bezugssignal vornimmt, das dem durch das RC-Glied geglätteten Signal entspricht, dadurch gekennzeichnet, daß der Kondensator (18) des RC-Gliedes über einen Schalter (20) zu- und abschaltbar ist und der Schalter (20) durch einen Störungsdetektor (30) steuerbar ist, der das elektrische Signal analysiert, wobei der Schalter (20) im Normalfall geöffnet ist und nur bei Auftreten von Störimpulsen geschlossen wird.

2. Schaltungsanordnung zur Unterdrückung von Störsignalen in einem eine NF-Information enthaltenden elektrischen Signal, mit einem im Signalweg liegenden integrierenden RC-Glied (16, 18), dem ein Spannungsteiler (14, 24, 26) vorgeschaltet ist, der ein nichtlineares Element (24, 26) enthält und eine Begrenzung innerhalb einer vorbestimmten Schwankungsbreite um das Bezugssignal vorninmt, das dem durch das RC-Glied geglätteten Signal entspricht, dadurch gekennzeichnet, daß ein steuerbarer Widerstand in Reihe mit dem Kondensator (18) des RC-Gliedes angeordnet und der Widerstandswert des steuerbaren Widerstandes durch ein Qualitätsbewertungssignal steuerbar ist, dessen Pegel eine Funktion des Störsignalanteiles in dem elektrischen Signal ist.

3. Schaltungsanordnung nach einem der Ansprüche 1 oder 2, dadurch gekennzeichnet, daß das nichtlineare Element aus zwei antiparallel geschalteten Dioden (24, 26) besteht.

4. Schaltungsanordnung nach einem der Ansprüche 1 bis 3, dadurch gekennzeichnet, daß dem RC-Glied (16, 18) ein Impedanzwandler (22) nachgeschaltet ist und das Bezugssignal durch das Ausgangssignal des Impedanzwandlers gebildet ist.

5. Schaltungsanordnung nach einem der vorstehenden Ansprüche, dadurch gekennzeichnet, daß dem Spannungsteiler ein Verstärker (12) vorgeschaltet ist, dessen Verstärkungsfaktor (V) auf die Strom/Spannungs-Kennlinie des nichtlinearen Elements (24, 26) im Sinne einer Optimierung der Störsignalunterdrückung abgestimmt ist.

6. Schaltungsanordnung nach den Ansprüchen 4 und 5, dadurch gekennzeichnet, daß dem Impedanzwandler (22) ein Spannungsteiler (28) nachgeschaltet ist, dessen Teilerverhältnis zumindest annähernd gleich dem Kehrwert des Verstärkungsfaktors (V) des Verstärkers (12) ist.

7. Schaltungsanordnung nach einem der Ansprüche 4 bis 6, dadurch gekennzeichnet, daß der Impedanzwandler durch einen Differenzverstärker (22) gebildet ist, dessen Ausgang auf den invertierenden Eingang rückgekoppelt ist und an dessen nichtinvertierenden Eingang das Ausgangssignal des RC-Gliedes (16, 18) angelegt ist.

8. Schaltungsanordnung nach Anspruch 7, dadurch gekennzeichnet, daß der Ausgang des Differenzverstärkers (32, 34) über wenigstens eine Diode des nichtlinearen Elements (24, 26) mit dem Eingang des RC-Gliedes verbunden ist.

9. Schaltungsanordnung nach einem der Ansprüche 3 bis 8, dadurch gekennzeichnet, daß an die Dioden (24, 26) eine vorspannung angelegt ist.

10. Schaltungsanordnung nach einem der vorstehenden Ansprüche, dadurch gekennzeichnet, daß es sich bei dem elektrischen Signal um ein Multiplex-Signal eines Autoradios handelt.

## Claims

1. A circuit arrangement for suppression of interference signals in an electrical signal containing low-frequency information, comprising an RC module (16, 18) with a capacitor and a resistor provided in the signal path, and a voltage divider (14, 24, 26) preceding said RC module, said voltage divider containing a nonlinear element (24, 26) and performing a limitation within a predetermined range of variation with respect to a reference signal which corresponds to said signal smoothed by said RC module, characterized in that the capacitor (18) of the RC module can be connected and disconnected via a switch (20) and said switch is controllable by an interference detector (30) which analyzes said electrical signal, said switch (20) being normally open and being closed only on occurrence of interference pulses.

2. A circuit arrangement for suppression of interference signals in an electrical signal containing low-frequency information, comprising an RC module (16, 18) with a capacitor and a resistor provided in the signal path, and a voltage divider (14, 24, 26) preceding said RC module, said voltage divider containing a nonlinear element (24, 26) and performing a limitation within a predetermined range of variation with respect to a reference signal which corresponds to said signal smoothed by said RC module, characterized in that a controllable resistor is arranged in series with said capacitor (18) of the RC module and in that the value of the controllable resistor is controllable by a quality rating signal, the level of which is a function of the interference signal component in said electrical signal.

3. The circuit arrangement according to claim 1 or claim 2, characterized in that said nonlinear element comprises two diodes (24, 26) connected in parallel and in opposite directions.

4. The circuit arrangement according to any one of claims 1 to 3, characterized in that wherein said RC module (16, 18) is followed by an impedance converter (22) and said reference signal is formed by an output signal of said impedance converter.

5. The circuit arrangement according to any one of the preceding claims, characterized in that said voltage divider is preceded by an amplifier (12) which has a gain (V) adapted to the current/voltage characteristic of said nonlinear element (24, 26) to optimize interference signal suppression.

6. The circuit arrangement according to claims 4 and 5, characterized in that said impedance converter (22) is followed by a voltage divider (28) having a division ratio which is at least approximately equal to the reciprocal of the gain (V) of said amplifier (12).

7. The circuit arrangement according to any one of claims 4 to 6, characterized in that said impedance converter is formed by a differential amplifier (22), the output of which is fed back to an inverting input thereof and to the noninverting input of which the output of said RC module (16, 18) is applied.

8. The circuit arrangement according to claim 7, characterized in that said differential amplifier (32, 34) has its output connected via at least one diode of the nonlinear element (24, 26) to the input of said RC module.

9. The circuit arrangement according to any one of claims 3 to 8, characterized in that a bias potential is applied to said diodes (24, 26).

10. The circuit arrangement according to any one of the preceding claims, characterized in that said electrical signal is a multiplex signal of a radio receiver.

## Revendications

1. Dispositif formant circuit pour la suppression de signaux parasites dans un signal électrique contenant une information BF, comprenant un circuit RC (16, 18) intégrateur, situé sur le passage du signal, en amont duquel est installé un diviseur de tension (14, 24, 26) qui comporte un élément non linéaire (24, 26) et assure une limitation à l'intérieur d'une largeur de variation prédéterminée autour du signal de référence qui correspond au signal lissé par le circuit RC, caractérisé en ce que le condensateur (18) du circuit RC peut être ouvert et fermé par l'intermédiaire d'un interrupteur (20) et en ce que l'interrupteur (20) peut être commandé par un détecteur de perturbations (30) qui analyse le signal électrique, l'interrupteur (20) étant ouvert dans le cas normal et n'étant fermé qu'en cas d'apparition d'impulsions parasites.

2. Dispositif formant circuit pour la suppression de signaux parasites dans un signal électrique contenant une information BF, comprenant un circuit RC (16, 18) intégrateur, situé sur le passage du signal, en amont duquel est installé un diviseur de tension (14, 24, 26) qui comporte un élément non linéaire (24, 26) et assure une limitation à l'intérieur d'une largeur de variation prédéterminée autour du signal de référence qui correspond au signal lissé par le circuit RC, caractérisé en ce qu'une résistance, pouvant être commandée, est disposée en série avec le condensateur (18) du circuit RC et en ce que la valeur de résistance de la résistance pouvant être commandée peut être commandée par un signal d'analyse de qualité dont le niveau est une fonction de la proportion de signal parasite présente dans le signal électrique.

3. Dispositif formant circuit selon l'une des revendications 1 ou 2, caractérisé en ce que l'élément non linéaire se compose de deux diodes (24, 26) montées tête-bêche.

4. Dispositif formant circuit selon l'une des revendications 1 à 3, caractérisé en ce qu'un convertisseur d'impédance (22) est monté en aval du circuit RC (16, 18) et en ce que le signal de référence est formé par le signal de sortie du convertisseur d'impédance.

5. Dispositif formant circuit selon l'une des revendications précédentes, caractérisé en ce que, en amont du diviseur de tension, il est monté un amplificateur (12) dont le facteur d'amplification (V) est accordé en fonction de la courbe caractéristique courant/tension de l'élément non linéaire (24, 26) dans le sens d'une optimisation de la suppression des signaux parasites.

6. Dispositif formant circuit selon les revendications 4 et 5, caractérisé en ce que, en aval du convertisseur d'impédance (22), il est monté un diviseur de tension (28) dont le rapport de diviseur est au moins presque identique à la valeur réciproque du facteur d'amplification (V) de l'amplificateur (12).

7. Dispositif formant circuit selon l'une des revendications 4 à 6, caractérisé en ce que le convertisseur d'impédance est formé par un amplificateur différentiel (22) dont la sortie est couplée en retour sur l'entrée inverseuse et au niveau de son entrée non inverseuse est appliqué le signal de sortie du circuit RC (16, 18).

8. Dispositif formant circuit selon la revendication 7, caractérisé en ce que la sortie de l'amplificateur différentiel (32, 34) est raccordée à l'entrée du circuit RC au moins par l'intermédiaire d'une diode de l'élément non linéaire (24, 26).

9. Dispositif formant circuit selon l'une des revendications 3 à 8, caractérisé en ce qu'une tension de polarisation est appliquée aux diodes (24, 26).

10. Dispositif formant circuit selon l'une des revendications précédentes, caractérisé en ce que, dans le cas du signal électrique, il s'agit d'un signal multiplex d'une autoradio.
